**Europäisches Patentamt**

(19) **European Patent Office**

**Office européen des brevets**

(11) Numéro de publication: **0 072 271**
**B1**

(12) # FASCICULE DE BREVET EUROPEEN

(45) Date de publication du fascicule du brevet:
16.01.85

(21) Numéro de dépôt: **82401301.5**

(22) Date de dépôt: **09.07.82**

(51) Int. Cl.⁴: **H 03 L 7/18**

---

(54) Synthétiseur de fréquence à large bande relative.

---

(30) Priorité: **24.07.81 FR 8114418**

(43) Date de publication de la demande:
**16.02.83 Bulletin 83/7**

(45) Mention de la délivrance du brevet:
**16.01.85 Bulletin 85/3**

(84) Etats contractants désignés:
**DE GB IT NL**

(56) Documents cités:
**FR - A - 1 473 202**

**ELECTRONICS LETTERS, vol. 14, no. 11, 25 mai 1978, pages 342-343, Londres, G.B., M.J. UNDERHILL et al.: "Fast digital frequency synthesiser"**

(73) Titulaire: **THOMSON-CSF, 173, Boulevard Haussmann, F-75379 Paris Cedex 08 (FR)**

(72) Inventeur: **Plouviez, Eric, THOMSON-CSF SCPI 173, bld Haussmann, F-75379 Paris Cedex 08 (FR)**

(74) Mandataire: **Lincot, Georges et al, THOMSON-CSF SCPI 173, Bld Haussmann, F-75379 Paris Cedex 08 (FR)**

ACTORUM AG

## Description

La présente invention concerne les synthétiseurs de fréquence à large bande relative qui permettent de générer une fréquence choisie parmi un jeu de fréquences s'étendant sur une très large gamme avec la précision et la stabilité d'une fréquence pilote de référence.

Les synthétiseurs de fréquence sont bien connus et sont pour la plupart constitués par un oscillateur dont la fréquence est commandée par une tension représentant la différence de phase entre un signal périodique de référence et un signal périodique obtenu par division, à l'aide d'un diviseur, de la fréquence du signal fourni par l'oscillateur.

A l'équilibre, la fréquence de l'oscillateur est égale à la fréquence de référence multipliée par le rapport de division.

Un exemple de réalisation d'un synthétiseur de ce type est décrit dans le brevet français N° 1473202. Le synthétiseur décrit permet, lorsque l'on change le rapport de division, d'obtenir un jeu de fréquences discrètes dont la précision et la stabilité sont liées à la précision ou à la stabilité de la fréquence du signal de référence. Le jeu de fréquence obtenu est compris entre deux valeurs de fréquence qui dépendent des possibilités de programmation du diviseur et de l'excursion en fréquence maximale, possible de l'oscillateur.

Un problème se pose cependant, lorsque la fréquence de l'oscillateur doit varier dans une bande de fréquence étendue, car, dans ce cas, la variation du rapport de division rend l'asservissement en phase, de la fréquence divisée, sur la fréquence de référence, très difficile à stabiliser et, d'autre part, l'excursion en fréquence maximum de l'oscillateur n'est pas toujours suffisante pour permettre la variation de fréquence souhaitée.

Pour corriger l'instabilité de l'asservissement en phase provoquée par l'augmentation du rapport de division une solution consiste à introduire dans la boucle de l'asservissement en phase un convertisseur digital analogique monté en atténuateur de la tension de commande de l'oscillateur, et commandé de façon numérique pour compenser les variations du gain de la boucle d'asservissement dues à une variation trop importante du rang du diviseur. Seulement, la solution analogique adoptée introduit du bruit sur l'entrée de commande de l'oscillateur, ce qui rend sa mise en œuvre délicate et nécessite des circuits de réglage supplémentaires pour annuler les écarts de fréquence provoqués par les tensions de bruit délivrées par le convertisseur digital-analogique.

Pour obtenir une variation en fréquence du synthétiseur compatible avec les possibilités d'excursion en fréquence de l'oscillateur on connaît également une solution qui est également décrite dans le brevet N° 1473202 et qui consiste à placer en série avec un diviseur à rang variable un diviseur à plusieurs étages fixes, identiques étage par étage, c'est-à-dire ayant la même capacité de division et à diviser, par un diviseur à plusieurs étages également fixes, la fréquence de référence avant son application à l'entrée du comparateur de phase. La mise en œuvre de cette solution est compliquée car elle nécessite l'emploi de commutateurs doubles pour introduire dans les deux chaînes de division précédemment constituées les divers étages de division et d'un oscillateur qui soit capable de s'accorder dans une bande de fréquence s'étendant au minimum sur une octave.

Les difficultés précitées peuvent être en partie résolues en réalisant un synthétiseur de fréquence à hétérodynage utilisant un oscillateur à faible excursion de fréquence et un mélangeur de fréquences permettant d'obtenir, à partir d'un signal mélangeur, un signal dont la fréquence représente la différence des fréquences du signal mélangeur et de la fréquence fournie par l'oscillateur. Les produits d'intermodulation sont éliminés par un filtre passe-bas qui délivre le signal de sortie souhaité.

La précision et la stabilité du signal mélangeur sont du même ordre de grandeur que celles du signal de référence, du reste, ces deux signaux peuvent être obtenus à partir d'une même source, par exemple par des divisions différentes de la fréquence d'un signal délivré par un générateur haute fréquence.

Si ce dispositif est moins délicat et présente de meilleures performances que celui où l'on emploie un oscillateur accordable sur une large bande, il reste néanmoins compliqué, notamment à cause de la nécessité d'employer un filtre passe-bas de haute performance à la sortie du mélangeur. D'autre part, l'emploi d'un mélangeur entraîne une dégradation du bruit de phase et dans le cas où le signal de sortie du synthétiseur est employé pour synchroniser une transmission de données numériues, le bruit de phase peut occasionner une erreur de synchronisation qui n'est pas constante dans la gamme de fréquence obtenue.

Le but de l'invention est de pallier les inconvénients précités à l'aide d'un synthétiseur, capable de synthétiser des fréquences dans une bande de fréquence relative supérieure à celle de la bande de fréquence d'accord de l'oscillateur, tout en ayant un oscillateur à faible bande de fréquence d'accord, un gain de boucle d'asservissement de phase réduit et à peu près constant sur toute la gamme de fréquence synthétisée et possédant également une précision et un bruit de phase nettement améliorés par rapport aux synthétiseurs déjà existants.

A cet effet l'invention a pour objet un synthétiseur de fréquence à large bande relative, du type comprenant un oscillateur commandé en tension, un diviseur pour diviser par un nombre entier la fréquence du signal fourni par l'oscillateur, un comparateur de phase pour comparer le signal délivré par le diviseur à un signal pilote de fréquence constante et délivrer un signal d'erreur mesurant l'écart de fréquence et de phase entre les signaux comparés et des moyens pour commander l'oscillateur par ce signal d'erreur, caractérisé en ce que le diviseur comprend deux étages ayant des rangs de division programmable et le signal synthétisé est prélevé sur la liaison entre ces deux étages.

D'autres particularités et avantages de l'invention apparaîtront clairement dans la description suivante faite en regard des figures annexées, données uniquement à titre d'exemple et dans lesquelles:

La fig. 1 représente le schéma d'un synthétiseur selon l'invention.

La fig. 2 représente un schéma de réalisation du synthétiseur de la fig. 1.

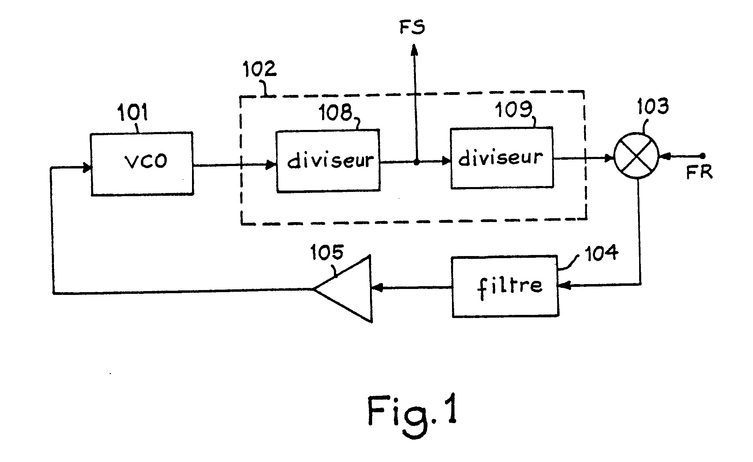

Le synthétiseur représenté schématiquement à la fig. 1 comprend un oscillateur 101 type VCO, VCO étant ici l'abréviation du terme anglo-saxon Voltage Control Oscillator, un diviseur de fréquence 102, un comparateur de phase 103, un filtre 104, et un amplificateur 105. Le diviseur de fréquence 102 est constitué par deux étages de division 108 et 109 montés en série. L'oscillateur 101 est commandé en tension par la sortie de l'amplificateur 105. La fréquence de l'oscillateur 101 est appliquée à l'entrée de l'étage 108 du diviseur 102. Le signal FS à la fréquence désirée est pris à la sortie du premier étage 108 entre les étages 108 et 109. Le signal en sortie du diviseur 102 est fourni par l'étage 109 et est appliqué à une entrée du comparateur de phase 103 dont l'autre entrée reçoit un signal de référence FR dont la fréquence est stable et précise. La sortie du comparateur 103 délivre une tension qui est une fonction de l'écart de fréquence entre les deux signaux de fréquence FR et FS appliqués sur ses entrées avant l'accrochage de la boucle de phase, puis lorsque la boucle de phase est accrochée cette tension est à peu près proportionnelle à l'écart de phase entre ces deux signaux. La tension de sortie du comparateur 103 est appliquée à l'entrée du filtre 104 qui permet de stabiliser la réponse de la boucle. La sortie du filtre 104 est reliée à l'entrée de l'amplificateur 105 qui amplifie la tension fournie par le filtre 104 à un niveau convenable pour commander l'oscillateur 101. Le bouclage ainsi réalisé se fait en rétroaction de telle manière que la tension d'erreur, fournie par le comparateur de phase 103, tende à ramener la fréquence du signal délivré par l'oscillateur 101 à une valeur telle que, après division dans le diviseur 102, la fréquence du signal en sortie de celui-ci soit égale à la fréquence du signal de référence FR. Lorsque l'accrochage en fréquence est réalisé, le système se stabilise, pour maintenir un écart de phase sensiblement constant entre le signal FR et le signal FS, de manière qu'il reste accroché. Dans ces conditions, si N1 désigne le rang de division du premier étage 108, et N2 le rang de division du deuxième étage 109, la fréquence du signal de sortie FS sera égale au produit de la fréquence du signal pilote FR par N2 à la condition que le produit de la fréquence de FS par N1 soit situé dans la bande d'accord de l'oscillateur 101. Comme on peut agir sur les rangs de division N1 et N2 des deux étages de division 108 et 109, il est possible d'obtenir sur une faible bande d'accord de l'oscillateur 101 une gamme beaucoup plus large de fréquences synthétisables que ne le permettent les synthétiseurs précités de l'art antérieur.

Comme les rangs de division des deux diviseurs 108 et 109 peuvent tous deux avoir la valeur 1, on voit que la plus faible fréquence qui est synthétisable est la fréquence de référence FR et que la plus haute fréquence synthétisable est le plus grand multiple entier de la fréquence de référence FR compris dans la bande d'accord de l'oscillateur.

En fait, dans ces conditions, dès que cette bande d'accord descend en dessous d'une valeur relative, définie comme étant le rapport de la bande d'accord à la fréquence minimale, de cent pour cent, on constate que les fréquences supérieures se groupent par paquets de fréquences séparées de la valeur de FR; ces paquets étant eux-mêmes séparés par des trous à chaque changement de division du premier diviseur 108. Lorsque ce rang de division atteint une valeur entière NO définie par la formule:

$$\frac{1}{NO} \leqslant \frac{F_{max.} - F_{min.}}{F_{min.}},$$

l'échelle des fréquences alors obtenue est continue à partir d'une fréquence déterminée par le plus grand multiple de la fréquence de référence FR compris dans la bande d'accord de l'oscillateur divisée par NO. Cela définit la gamme de fréquences synthétisables présentant effectivement un intérêt pratique.

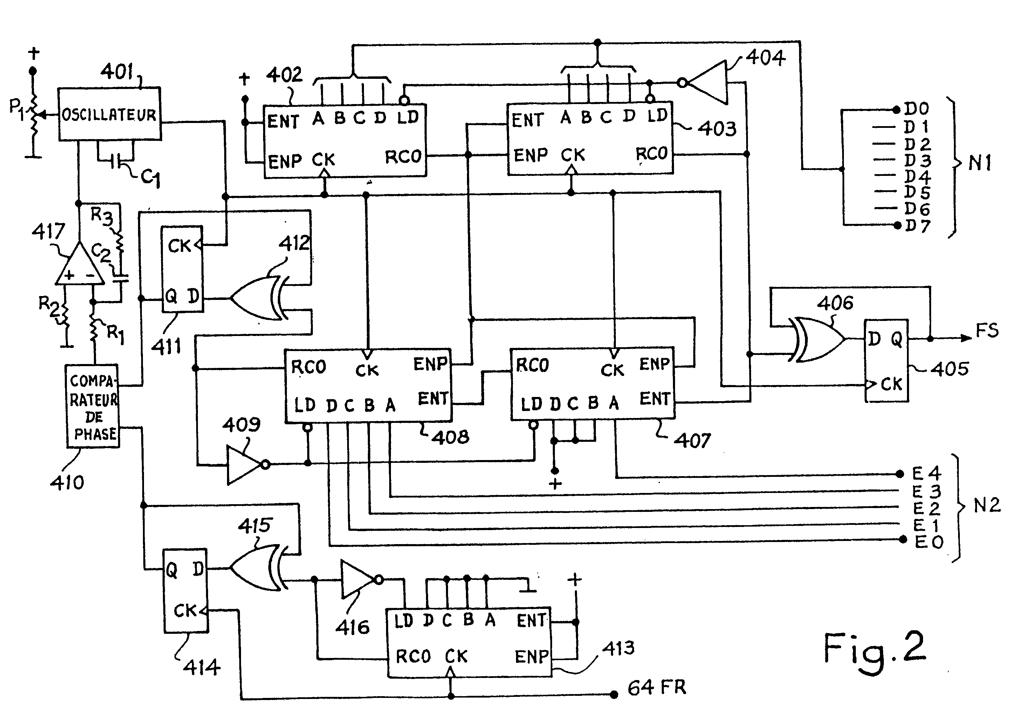

Une réalisation pratique du schéma théorique de la fig. 1 est représentée sur la fig. 2. Elle permet d'obtenir 32 signaux de synchronisation correspondant à 32 fréquences multiples d'une fréquence de référence de base FR de 64 kHz. Ce générateur permet par exemple de synchroniser 32 débits distincts sur un réseau numérique.

L'oscillateur 401 commandé en tension est un multivibrateur du type 74S124 accordé par un potentiomètre extérieur P1 de 4,7 kΩ et une capacité extérieure C1 de 39 pF pour osciller librement à environ 6,9 MHz.

Le signal de sortie de ce multivibrateur est appliqué à un premier diviseur formé de deux circuits 402 et 403 du type 74LS163 connectés en série à l'aide notamment d'un amplificateur inverseur extérieur 404 du type 74LS04 attaqué par la sortie du circuit 403 et venant commander les entrées LD des deux circuits 402 et 403. Les entrées ABCD de chacun des circuits 402 et 403 sont connectées en parallèle à des bornes D0 à D7 qui permettent par un jeu d'interrupteurs non représentés de programmer le rang de division du compteur formé par les circuits 402 et 403 sur le nombre N1 désiré choisi entre 2 et 64.

Le signal obtenu en sortie RCO du circuit 403 est appliqué à un étage diviseur par 2 formé de la bascule 405 du type 74LS74 connecté avec le circuit OU-EXCLUSIF 406 du type 74LS86 entre son entrée et sa sortie. Le signal FS désiré est obtenu sur la sortie Q du circuit 405.

Le signal en sortie RCO du premier diviseur est également appliqué à un second diviseur formé des circuits 407 et 408 du type 74LS163 connectés en série à l'aide d'un amplificateur inverseur 409 du type 74LS04. Les entrées DCBA du circuit 408 et A du circuit 407 sont réunies en parallèle à un ensemble de bornes E0 à E4 qui permettent, à l'aide d'un ensemble d'interrupteurs non représentés, de programmer le rang de division N2 du deuxième diviseur formé par les circuits 407 et 408, de 1 à 32. Les entrées de programmation B à D du circuit 407 ne sont pas utilisées et sont réunies à une source de tension positive adéquate.

La sortie RCO du circuit 408 est réunie à un comparateur de phase 410 du type MC4044 par l'intermédiaire d'un diviseur par 2 formé des circuits 411 et 412 et identique à celui formé par les circuits 405 et 406.

Le signal pilote de référence a dans cette réalisation une fréquence de 2048 kHz, parce qu'il correspond à un signal pilote disponible dans l'équipement pour lequel le synthétiseur est adapté. Ce signal 64 FR est tout d'abord divisé par 32 dans un diviseur formé d'un circuit 413 du type 74LS163 connecté avec un amplificateur inverseur 416 du type 74LS04 connecté entre sa sortie RCO et son entrée LD. Les entrées ABCD de programmation du circuit 413 ne sont pas utilisées et sont reliées à la masse. Les entrées ENT et ENP, non utilisées, sont elles reliées à une source positive. Le signal en sortie RCO de ce diviseur est appliqué au comparateur de phase 410 par l'intermédiaire d'un diviseur par 2 formé des circuits 414 et 415 et identique au circuit formé des circuits 405 et 406.

Le signal d'erreur, provenant de la comparaison des deux signaux en entrée du comparateur de phase 410, est appliqué, par l'intermédiaire d'une résistance R1 de 22 kΩ, à l'entrée inverseuse d'un amplificateur 417 différentiel de type TDB156 dont l'entrée non inverseuse est réunie à la masse par une résistance R2 de même valeur. La tension d'erreur ainsi amplifiée obtenue en sortie de l'amplificateur 417 est appliquée à l'entrée de contrôle de fréquence du multivibrateur 401. Elle est également appliquée en rétroaction sur l'entrée inverseuse de l'amplificateur 417 par une cellule de filtrage formée d'une résistance R3 de 3,3 kΩ en série avec un condensateur C2 de 1 μF.

Dans ces conditions, le gain en boucle ouverte de la boucle d'asservissement de phase est suffisamment constant quelles que soient les variations de rang de division ou des diviseurs dans la gamme désirée, ce qui permet d'avoir un asservissement stable et un bruit de phase minimum. On peut ainsi obtenir les fréquences multiples de 1 à 32, soit 5 octaves, de la fréquence de référence FR à 64 kHz. Les valeurs extrêmes que doit prendre le produit N1 · N2 pour N2 variant de 1 à 32 et FS de 64 kHz à 2048 kHz sont alors 78 (pour N2 = 26, FS = 1664 kHz, N1 = 3) et 54 (pour N2 = 27, FS = 1728 kHz, N1 = 2). L'oscillateur devra donc être capable de couvrir la plage de fréquences comprises entre 9984 et 6912 kHz compte tenu de la division par 2 dans le circuit 405/406. La variation de gain en boucle ouverte est inférieure sur toute cette gamme à 4 dB.

## Revendications

1. Synthétiseur de fréquence à large bande relative, du type comprenant un oscillateur commandé en tension (101 ; 401), un diviseur (102) pour diviser par un nombre entier la fréquence du signal fourni par l'oscillateur, un comparateur de phase (103) pour comparer le signal délivré par le diviseur à un signal pilote de fréquence constante (FR) et délivrer un signal d'erreur mesurant l'écart de fréquence et de phase entre les signaux comparés, et des moyens (104, 105) pour commander l'oscillateur par ce signal d'erreur, caractérisé en ce que le diviseur comprend deux étages (108, 109 ; 402-403, 407-408) ayant des rangs de division programmable et en ce que le signal synthétisé (FS) est prélevé sur la liaison entre ces deux étages.

2. Synthétiseur selon la revendication 1, caractérisé en ce que les moyens de commande de l'oscillateur comprennent un filtre (104) et un amplificateur (105) pour obtenir une tension de commande qui agisse en contre-réaction sur l'oscillateur avec un gain en boucle ouverte de la boucle d'asservissement de phase sensiblement constant sur toutes les fréquences délivrées par le synthétiseur.

3. Synthétiseur selon l'une des revendications 1 ou 2, caractérisé en ce qu'il comprend en outre des moyens (413-416) pour obtenir par division le signal pilote à partir d'un autre signal pilote à une fréquence plus élevée.

4. Synthétiseur selon l'une des revendications 1 à 3, caractérisé en ce que la fréquence de référence est sensiblement égale à 64 kHz et que le deuxième étage du diviseur (407, 408) peut être programmé pour un rang de division allant de 1 à 32; le synthétiseur pouvant alors fournir les 32 premières fréquences multiples de 64 kHz s'étendant sur une gamme de 5 octaves.

5. Synthétiseur selon la revendication 4, caractérisé en ce que l'oscillateur (401) est accordable entre 6,9 et 10 MHz, et que le premier étage (402, 403) du diviseur est programmable sur un rang de division allant de 2 à 40.

## Patentansprüche

1. Frequenzsyntheseeinrichtung mit grosser relativer Bandbreite, mit einem spannungsgesteuerten Oszillator (101 ; 401), einem Teiler (102) zur Teilung der Frequenz des von dem Oszillator gelieferten Signals durch eine ganze Zahl, einem Phasenkomparator (103) zum Vergleichen dieses von dem Teiler abgegebenen Signals mit einem Pilotsignal konstanter Frequenz (FR) und A: :eben eines Fehlersignals, das ein Mass für die Frequenz- und Phasenabweichung zwischen den verglichenen Signalen ist, und Mitteln (104, 105) zur Steuerung des Oszillators durch dieses Fehlersignal, dadurch gekennzeichnet, dass der Teiler zwei Stufen (108, 109 ; 402-403, 407-408) umfasst, die programmierbare Teilerränge aufweisen, und dass das durch Synthese gewonnene Signal (FS) an der Verbindung zwischen diesen beiden Stufen abgenommen wird.

2. Syntheseeinrichtung nach Anspruch 1, dadurch gekennzeichnet, dass die Mittel zur Steuerung des Oszillators ein Filter (104) und einen Verstärker (105) zur Gewinnung einer Steuerspannung umfassen, die als Gegenkopplung auf den Oszillator einwirkt, mit einer Leerlaufverstärkung der Phasenregelschleife, die bei allen von der Syntheseeinrichtung abgegebenen Frequenzen im wesentlichen konstant ist.

3. Syntheseeinrichtung nach Anspruch 1 oder 2, dadurch gekennzeichnet, dass sie ferner Mittel (413-416) umfasst, um das Pilotsignal durch Teilung aus einem weiteren Pilotsignal höherer Frequenz zu gewinnen.

4. Syntheseeinrichtung nach einem der Ansprüche 1 bis 3, dadurch gekennzeichnet, dass die Bezugsfrequenz im wesentlichen gleich 64 kHz ist und dass die zweite Stufe des Teilers (407, 408) für einen Teilerrang programmiert werden kann, der sich von 1 bis 32 erstreckt; wobei die Syntheseeinrichtung dann die 32 ersten Vielfachfrequenzen von 64 kHz liefern kann, welche sich über einen Bereich von 5 Oktaven erstrecken.

5. Syntheseeinrichtung nach Anspruch 4, dadurch gekennzeichnet, dass der Oszillator (401) zwischen 6,9 und 10 MHz abstimmbar ist und dass die erste Stufe (402, 403) des Teilers auf einen Teilerrang programmierbar ist, der sich von 2 bis 40 erstreckt.

## Claims

1. Frequency synthesizer having a wide relative band, of the type comprising a voltage controlled oscillator (101; 401), a divider (102) for dividing the frequency of the signal supplied by the oscillator through an integer, a phase comparator (103) for comparing the signal supplied by the divider to a pilot signal of constant frequency (FR) and supplying an error signal measuring the frequency and phase shift between the compared signals, and means (104, 105) for controlling the oscillator by this error signal, characterized in that the divider comprises two stages (108, 109; 402-403, 407-408) having programmable orders of division and in that the synthesized signal (FS) is derived at the connection between these two stages.

2. Synthesizer according to claim 1, characterized in that the control means of the oscillator comprise a filter (104) and an amplifier (105) for obtaining a control voltage used in a negative feedback of the oscillator with an open loop gain of the phase control loop which is substantially constant for all of the frequencies supplied by the synthesizer.

3. Synthesizer according to any of claims 1 and 2, characterized in that it further comprises means (413-416) for obtaining the pilot signal by division from a further pilot signal having a higher frequency.

4. Synthesizer according to any of claims 1 to 3, characterized in that the reference frequency is substantially equal to 64 kHz and in that the second stage of the divider (407, 408) is programmable for an order of division extending from one to 32; the synthesizer being able to supply the 32 first multiple frequencies of 64 kHz extending over a range of 5 octaves.

5. Synthesizer according to claim 4, characterized in that the oscillator (401) is tunable between 6.9 and 10 MHz and in that the first stage (402, 403) of the divider is programmable to an order of division extending from 2 to 40.

0 072 271

Fig.1

7

Fig.2